# EUROPÄISCHE PATENTANMELDUNG

(11) **EP 0 669 441 A1**
(43) Veröffentlichungstag der Anmeldung: **30.08.1995**
(21) Anmeldenummer: 94118553.0
(22) Anmeldetag: 25.11.1994
(51) Int. Cl.: E05D 15/50

(54) **Gehäuse mit Abdeckung und gegebenenfalls Zwischenrahmen**

(30) Priorität: 24.02.1994 DE 4405947
(71) Anmelder: BOPLA GEHÄUSE SYSTEME GmbH, D-32257 Bünde (DE)
(72) Erfinder: Behrendt, Horst, D-32584 Löhne (DE); Krömer, Andreas, D-32049 Herford (DE); Niehausmeier, Uwe, D-32289 Rödinghausen (DE); Spilker, Friedhelm, D-32278 Kirchlengern (DE)
(74) Vertreter: Patentanwälte Dipl.-Ing. Bodo Thielking Dipl.-Ing. Otto Elbertzhagen

(57) **Zusammenfassung**

Ein Gehäuse ist mit einer Abdeckung (3) versehen, die daran mittels eines Spannverschlusses (4,7) befestigbar ist. Während übliche Spannverschlüsse an solchen Gehäusen lediglich ein schnelles vollständiges Entfernen bzw. einen schnellen Zusammenbau bewirken, erlaubt die erfindungsgemäße Konstruktion je nach Betätigungsstellung des Spannverschlusses entweder eine vollständige Trennung der Gehäuseteile (1;2;3) voneinander oder die Bildung einer Scharnierverbindung zwischen den beiden Gehäuseteilen.

## Beschreibung

Die Erfindung betrifft ein Gehäuse nach dem Oberbegriff des Anspruchs 1.

Bei derartigen Gehäusen (US 3,464,579) werden die Abdeckungen oder Gehäusedeckel an dem darunterliegenden Gehäuseteil mit Hilfe von Spannverschlüssen fixiert, die nach dem Über-Totpunkt-Prinzip arbeiten. Das Zugorgan ist dabei als am Spannhebel angelenktes Element ausgebildet, welches um eine parallel zur Schwenkachse des Spannhebels angelenkte Achse verschwenkbar ist. Das Zugelement besitzt an seinem vom Spannhebel entfernt liegenden Ende ein bolzenartiges Querstück, das in ein hakenförmiges Gegenstück des anderen Gehäuseteils eingreift.

Es ist auch bekannt, das Zugorgan als am Spannhebel angelenkte Zugöse auszubilden, welche eine Nase des gegenüberliegenden Gehäuseteils übergreift.

Mit derartigen Spannverschlüssen können zwar die Gehäuseteile schnell und fest miteinander verbunden werden, sie sind bei Bedarf auch schnell voneinander lösbar. Nachteilig ist dabei jedoch die Tatsache, daß die Gehäusedeckelstets vollständig vom angrenzenden Gehäuseteil entfernt werden müssen und nicht am dem Deckel benachbarten Gehäuseteil verbleiben.

Es ist ferner bekannt, die Gehäusedeckel an die darunterliegenden Gehäusebereiche, also ein Basisteil oder in mit dem Basisteil verbundenen Zwischenrahmen mittels eines Scharniers anzulenken.

Bei diesen Konstruktionen kann der Deckel in Öffnungslage verschwenkt werden und verbleibt an dem zugehörigen Gehäuseteil. Es ist jedoch aufwendig, wenn nicht sogar vollständig unmöglich, bei derartigen Scharnierkonstruktionen den Gehäusedeckel bei Bedarf vollständig zu entfernen, wenn dies beispielsweise für einen besseren Zugang zum Gehäuseinneren wünschenswert ist.

Ausgehend von dem eingangs erwähnten Stand der Technik liegt der Erfindung die Aufgabe zugrunde, ein Gehäuse der bekannten Art so auszubilden, daß die Gehäuseteile nicht nur schnell und einfach voneinander lösbar sind, sondern daß darüber hinaus die Verbindungen zwischen den Gehäuseteilen auch eine scharnierende Verbindung erlauben.

Die Lösung dieser Aufgabe erfolgt mit den Merkmalen des Kennzeichnungsteils von Anspruch 1. Bevorzugte Ausgestaltungen sind in den Unteransprüchen beschrieben.

Das erfindungsgemäße Gehäuse vereinigt die Vorteile zweier unterschiedlicher Verbindungsprinzipien, ohne deren jeweilige Nachteile aufzuweisen. Je nach Art der Betätigung wird eine einwandfreie Scharnierverbindung zwischen den Gehäuseteilen erreicht oder die Verbindung wird vollständig aufgehoben. Dabei ist das vollständige Lösen in extrem kurzer Zeit ohne Zuhilfenahme von Werkzeugen möglich.

Nachstehend wird eine bevorzugte Ausführungsform der Erfindung anhand der Zeichnung im einzelnen beschrieben.

Es zeigen:

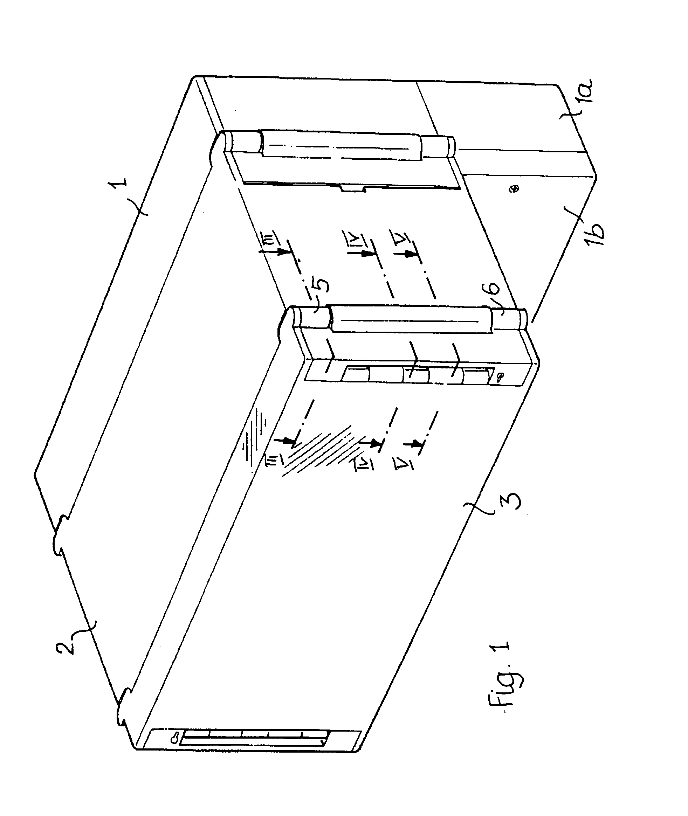

Figur 1 - eine perspektivische Gesamtansicht des Gehäuses, das im dargestellten Ausführungsbeispiel im wesentlichen aus Basisteil, Zwischenrahmen und Abdeckung besteht,

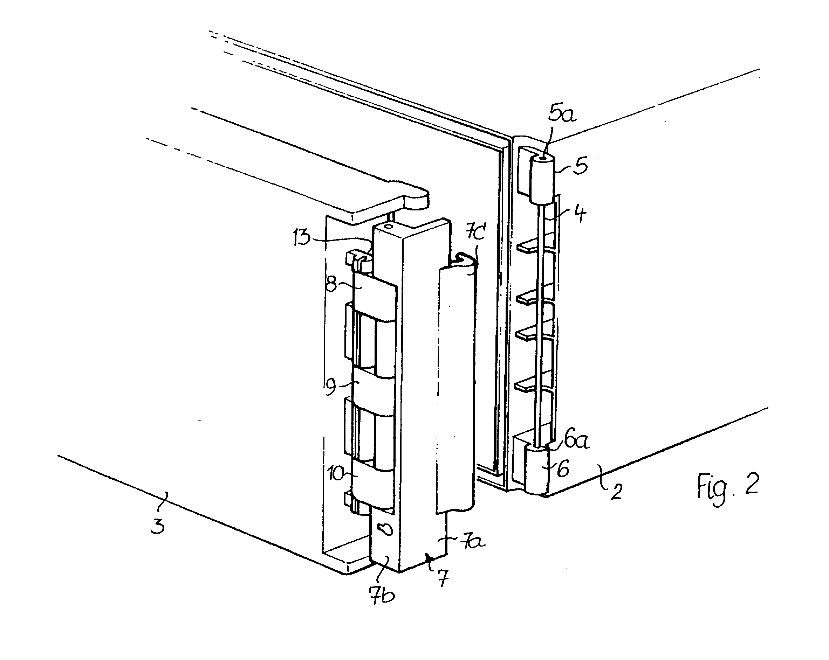

Figur 2 - eine perspektivische Explosionsdarstellung des rechten vorderen Frontbereichs von Abdeckung und Zwischenrahmen,

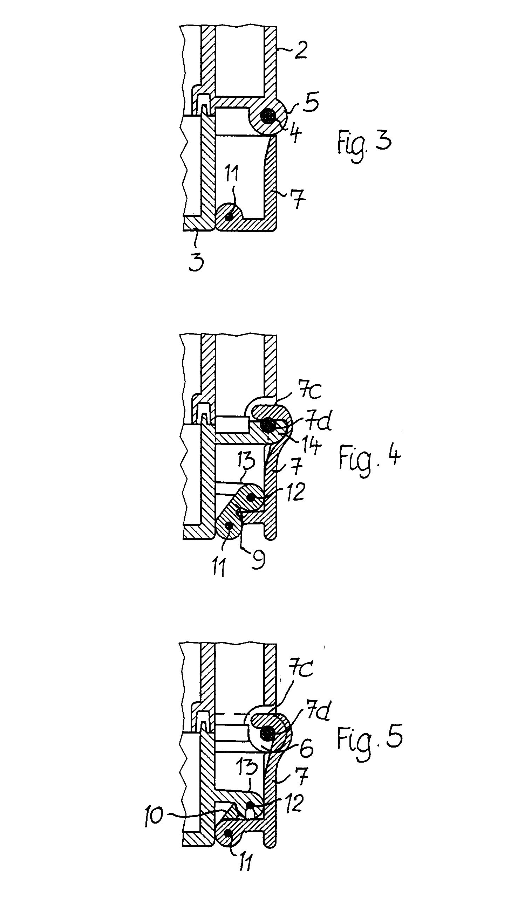

Figur 3 - einen Schnitt durch einen Teilbereich des Gehäuses entlang Ebene 111 - 111 gemäß Figur 1,
Figur 4 - einen zu Figur 3 analogen Schnitt entlang Ebene IV - IV in Figur 1,
Figur 5 - einen zu Figuren 3 und 4 analogen Schnitt entlang Ebene V - V in Figur 1,
Figuren 6a bis 6f - die Lage von Zwischenrahmenabdeckung und Spannverschluß bei einem Scharnierbetrieb,
Figuren 7a bis 7f - verschiedene Positionen von Zwischenrahmen 2, Abdeckung 3 und Spannverschluß in verschiedenen Öffnungs- bzw. Schließpositionen des Spannverschlusses zur Vorbereitung der vollständigen Abnahme der Gehäuseabdeckung.

Das Gehäuse besteht im dargestellten Ausführungsbeispiel aus einem Basisteil 1 mit einem Klemmenkasten 1 und einem Klemmenkastendekkel 1 b, ferner aus einem Zwischenrahmen 2 und einer Abdeckung 3.

Der Zwischenrahmen ist über einen Spannverschluß am Basisteil befestigt. Ferner ist die Abdekkung 3 über einen Spannverschluß am Zwischenrahmen 2 befestigt. Die am Zwischenrahmen und an der Abdeckung erläuterte Anordnung des Spannverschlusses wiederholt sich in analoger Weise an der Verbindungsstelle zwischen Zwischenrahmen 2 und Basisteil 1.

An dem Zwischenrahmen 2 sind zwei Lageraugen 5 und 6 angeformt. Eine Bohrung 5a im Lagerauge 5 und eine Bohrung 6a dienen zur Aufnahme einer Schwenkwelle 4.

An der Abdeckung 3 sind miteinander fluchtende Lageraugen 13 untereinander angeordnet, die jeweils eine fluchtende Lagerbohrung 12 aufweisen. Die Lagerbohrung 12 wird von einer gemeinsamen Welle durchsetzt, die ferner zwischen den einzelnen Lageraugen 13 angeordnete Doppelgelenkhebel 8, 9 und 10 durchsetzen. Die Doppelgelenkhebel 8, 9 und 10 stellen die Spannhebel eines Zugverschlusses dar. An den Spannhebeln 8, 9 und 10 sind über miteinander fluchtende Bohrungen 11 fluchtende Bereiche eines winkelförmigen Zugorgans 7 an den Spannhebeln angeschlossen. In den Zeichnungsfiguren 6a bis 6f sowie 7a bis 7f sind die Verhältnisse im Bereich des Spannhebels 9 dargestellt. Diese sind entsprechend im Bereich der beiden übrigen Spannhebel 8 und 10. Die Zahl der Spannhebel ist ohne weiteres veränderlich, ohne das Prinzip der neuen Lösung zu verändern.

Das Zugorgan 7 besitzt einen hakenförmigen Bereich 7c, der im Spannzustand des Spannverschlusses die Schwenkwelle 4 umgreift.

Der hakenförmige Bereich 7c des Zugorgans 7 weist eine in seiner Form und Anordnung der Schwenkwelle 4 entsprechende, in Schwenkachsrichtung verlaufende, runde Nut 7d auf. Ein Schenkel 7a des Zugorgans 7 liegt im Spannzustand des Spannverschlusses bündig mit der benachbarten Seitenfläche des Zwischenrahmens 2. Die nach vorne weisende Außenfläche 7a des Zugorgans 7 liegt im Spannzustand des Spannverschlusses im wesentlichen bündig mit der Frontfläche der Abdeckung 3.

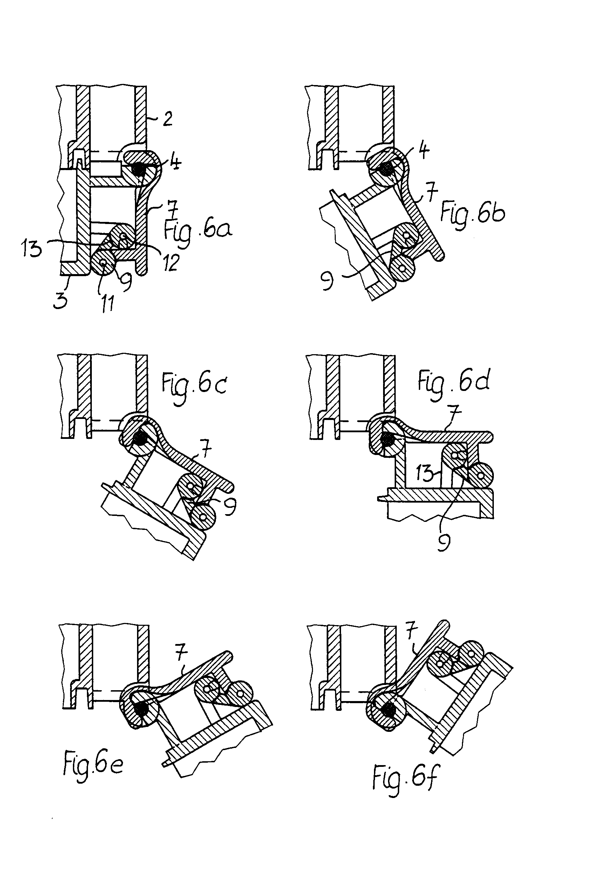

Figuren 6a bis 6f illustrieren den Schwenkvorgang zwischen Abdeckung 3 und Zwischenrahmen 2, wie er bei gespanntem Spannverschluß möglich ist. Der Spannverschluß führt dazu, daß die ortsfest am Zwischenrahmen gelagerte Schwenkwelle 7 einerseits fest umgriffen wird von den Lagerschalen 14a, welche an den Lagerbereichen 14 ausgebildet sind. Die Lagerbereiche 14 sind an die Abdeckung 3 angeformt. Die Lagerschalen 14a sind zum gegenüberliegenden Zwischenrahmen 2 hin offen ausgebildet, mit der Folge, daß die Abdeckung frei nach vorn abnehmbar ist, wenn das Zugorgan die in Figuren 6a bis 6f dargestellte Position nicht sichert. Da die Position bei einem scharnierenden Betrieb gemäß Figuren 6a bis 6f gesichert wird, ist ein Aufschwenken der Gehäuseabdeckung in der dargestellten Weise möglich.

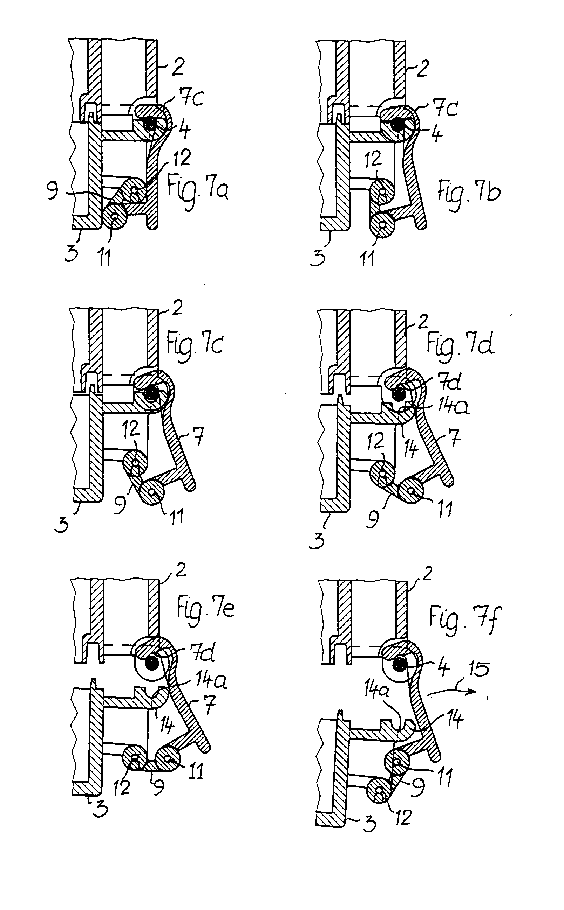

Wenn statt dessen die Gehäuseabdeckung vollständig entfernt werden soll, wird der Spannverschluß gelöst, wie dies in Figuren 7a bis 7f in verschiedenen Bewegungsstufen dargestellt ist. Nach Erreichen der Position gemäß Figur 7f wird das Zugorgan 7 in Richtung des Pfeils 15 auswärts geschwenkt und es kann dann die Abdeckung 3 vollständig abgenommen werden.

## Patentansprüche

1. Gehäuse mit Abdeckung und gegebenenfalls Zwischenrahmen, bei dem die Abdeckung und gegebenenfalls der Zwischenrahmen an einem Basisteil bzw. gegebenenfalls die Abdeckung am Zwischenrahmen mittels eines Spannverschlusses befestigbar sind, bei dem an einem schwenkbar an einem ersten Gehäuseteil gelagerten Spannhebel ein Zugorgan angelenkt ist, das einen am benachbarten zweiten Gehäuseteil vorgesehenen Anlagebereich übergreift und in Spannstellung die beiden Gehäuseteile zusammenspannt, wobei in ungespannter Stellung für ein Lösen der beiden Gehäuseteile voneinander das Zugorgan vom Anlagebereich lösbar ist,
dadurch gekennzeichnet,
daß das Zugorgan (7) eine Schwenkwelle (4) übergreift, die in miteinander axial fluchtenden Lagerbereichen (5; 6; 14) beider benachbarter Gehäuseteile (2 und 3 bzw. 1 und 3) gehaltert ist, wobei in Spannstellung von Spannhebel (8; 9; 10) und Zugorgan (7) die axial fluchtenden Lagerbereiche (5; 6; 14) beider Gehäuseteile, die Schwenkwelle (4) und das Zugorgan (7) ein Scharnier mit einer festen Schwenkachse bilden, um die ein Gehäuseteil (3) gegenüber dem anderen (2) verschwenkbar gelagert ist.

2. Gehäuse nach Anspruch 1,
dadurch gekennzeichnet,
daß der Spannhebel (8; 9; 10) an der Abdekkung (3) bzw. gegebenenfalls an dem Zwischenrahmen gelagert ist.

3. Gehäuse nach Anspruch 1 oder 2,
dadurch gekennzeichnet,
daß der Lagerbereich (14) für die Schwenkwelle (4) an einem Gehäuseteil (3) lediglich als zum gegenüberliegenden Ende hin offene Lagerschale (14a) ausgebildet ist.

4. Gehäuse nach einem oder mehreren der Ansprüche 1 bis 3,
dadurch gekennzeichnet,
daß die zum gegenüberliegenden Gehäuseteil hin offene Lagerschale (14a) an der Abdekkung (3) bzw gegebenenfalls am Zwischenrahmen (2) vorgesehen ist.

5. Gehäuse nach einem oder mehreren der Ansprüche 1 bis 4,
dadurch gekennzeichnet,
daß das Zugorgan (7) mittels mehrerer in Abständen voneinander angeordneter Spannhebel (8; 9; 10) am zugehörigen Gehäuseteil (3) angelenkt ist.

6. Gehäuse nach einem oder mehreren der Ansprüche 1 bis 5,
dadurch gekennzeichnet,
daß das Zugorgan (7) die Schwenkwelle (4) auf der gesamten Länge zwischen den Lagerbereichen (5; 6) des gegenüberliegenden Gehäuseteils (2) übergreift.

7. Gehäuse nach einem oder mehreren der Ansprüche 1 bis 6,
dadurch gekennzeichnet,
daß der die Schwenkwelle (4) umgreifende Bereich (7c) des Zugorgans (7) eine der Schwenkwelle (4) entsprechende, in Schwenkachsrichtung verlaufende, runde Nut (7d) aufweist.

8. Gehäuse nach einem oder mehreren der Ansprüche 1 bis 7,
dadurch gekennzeichnet,
daß das Zugorgan (7) zueinander rechtwinklig verlaufende Außenflächen (7a und 7b) aufweist, deren eine (7a) in Spannstellung mit der benachbarten Gehäusewand des benachbarten Gehäuseteils (2) fluchtet und deren andere (7b) in Spannstellung zumindest im wesentlichen bündig liegt mit der Frontfläche der Abdeckung (3).
